# EUROPEAN PATENT SPECIFICATION

(11) **EP 0 773 626 B1**
(45) Date of publication and mention of the grant of the patent: **06.12.2000**
(21) Application number: 96115182.6
(22) Date of filing: 20.09.1996
(51) Int. Cl.: H03L 1/02, H03K 3/011, H03K 3/03

(54) **Oscillator for oscillating stable frequency formed on a semiconductor substrate**
Auf einem Halbleitersubstrat hergestellter Oszillator stabiler Frequenz
Oscillateur à fréquence stable formé sur substrat semi-conducteur

(30) Priority: 13.11.1995 KR 4099095
(43) Date of publication of application: 14.05.1997
(73) Proprietor: SAMSUNG ELECTRONICS CO., LTD., Suwon-city, Kyungki-do 441-373 (KR)
(72) Inventor: Park, Hyung-Sik, Seodaemun-gu, Seoul (KR)
(74) Representative: Grünecker, Kinkeldey, Stockmair & Schwanhäusser Anwaltssozietät

(56) References cited:
- US-A- 5 180 995
- US-A- 5 465 063
- PATENT ABSTRACTS OF JAPAN vol. 006, no. 182 (E-131), 18 September 1982 & JP 57 097218 A (CITIZEN WATCH CO LTD), 16 June 1982,

## Description

The invention relates to a temperature compensated oscillator circuit of a semiconductor device as indicated in the precharacterizing part of claim 1 for oscillating at a stable frequency according to change of ambient temperature.

Generally, an oscillator circuit for generating a reference clock signal has been employed for a variety of electrical circuits. In particular, a crystal oscillator circuit including a crystal vibrator has been often used because it generates a clock signal which has an externally stable and constant frequency. However, such a crystal oscillator has been used with it being connected to printed circuit board of semiconductor integrated circuit device since it cannot be formed on a semiconductor substrate. This structure needs an additional device adapted to construct a circuit and also operation of the device is inevitably accompanied by additional time consumption. In addition, the crystal oscillator has a disadvantage that it is usually expensive. Accordingly, it is desirable to provide oscillator circuit on a semiconductor substrate which is low priced, as well as has a stable and constant oscillation frequency. However, the problems that an oscillation frequency of the on-chip oscillator is generally unstable, and in particular, influence of change of ambient temperature can not be avoided.

A prior art (US-A-5 180 995) temperature compensated oscillator circuit as indicated in the precharacterizing part of claim 1 is formed by a ring oscillator including inverters cascaded in a ring-like manner, a diffused resistor having a positive temperature coefficient and a polysilicon resistor having a negative temperature coefficient for determining bias currents supplied to the inverters. The oscillation frequency tends to decrease with a rise of ambient temperature based on a temperature characteristic of diffused resistor and a temperature characteristic of the oscillator circuit itself. The change of oscillation frequency is compensated by a temperature characteristic of the polysilicon resistor. Therefore, a reference clock signal generating circuit having an oscillation frequency which is not affected by change of the ambient temperature is formed in the semiconductor substrate.

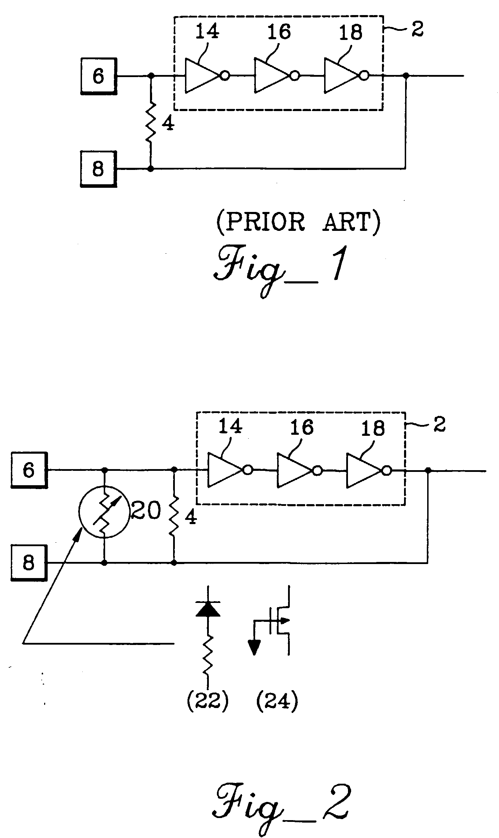

FIG. 1 is a diagrammatic view showing an oscillator circuit according to the prior art.

Referring to FIG.1, the oscillator circuit comprises a feedback resistance means 4 which is connected to an output terminal of an inverting means 2 including inverters 14, 16 and 18 connected to an input terminal 6 and which is connected between the input terminal 6 and the output terminal 8. The range of the change of the feedback resistance 4 is extremely large depending on temperature. For this reason, a change in frequency is unavoidable. In other words, there is a problem that, as described above, when temperature increases, both resistance values of the inverting means 2 and the feedback resistance 4 increase, but inversely frequency decreases. That is, this change in frequency responds sensitively to dynamic resistance corresponding to the change value in current of N channel and P channel driver depending on temperature, and the range of the change also responds sensitively to that depending on the size and temperature of a transistor.

It is the object of the invention to provide a temperature compensated oscillator circuit of a semiconductor device, oscillating at a stable frequency corresponding to change of temperature in a semiconductor substrate.

This object is solved by the features as claimed in claim 1.

A more complete appreciation of this invention, and many of the attendant advantages thereof, will be readily apparent as the same becomes better understood by reference to the following detailed description when considered in conjunction with the accompanying drawings, in which like reference symbols indicate the same or similar elements components, wherein:
FIG. 1 is a diagrammatic view showing an oscillator circuit according to the prior art;
FIG. 2 is a diagrammatic view showing an oscillator circuit according to an embodiment of the invention; and
FIG. 3 is a graphic view showing results of frequency properties on temperature according to FIG. 2.

Referring to FIG. 2, the present circuit comprises a feedback resistance means 4 connected to the output terminal of an inverting means 2 including inverters 14, 16 and 18 connected to an input terminal 6, and connected between the input terminal 6 and the output terminal 8, and a temperature compensating means 20 connected parallel with the feedback resistance means 4, and connected between the input terminal 6 and the output terminal 8. In other words, in order to minimize a change in frequency, the temperature compensating means 20 may include a circuit adapted to decrease a change in resistance value corresponding to increase in temperature, i.e. a diode and a resistance 22, or may be a transistor 24 whose gate is connected to ground, is additionally provided to the oscillator circuit.

If resistance values of the inverting means 2 and the feedback resistance means 4 decrease due to increase in temperature, and the resistance of temperature compensating means 20 as resistance in a normal condition decreases due to increase in temperature, the following equation is established:$\text{R2+R4 > R2+(R2+R4) / R4·R20 ... (Formular)} \text{(∴R4 > (R4+R20) R4·R20)}$

That is, as feedback resistance 4 and resistance of the temperature compensating means 20 are always connected in parallel with each other, they become less than the feedback resistance 4 although the resistance of the temperature compensating means is large.

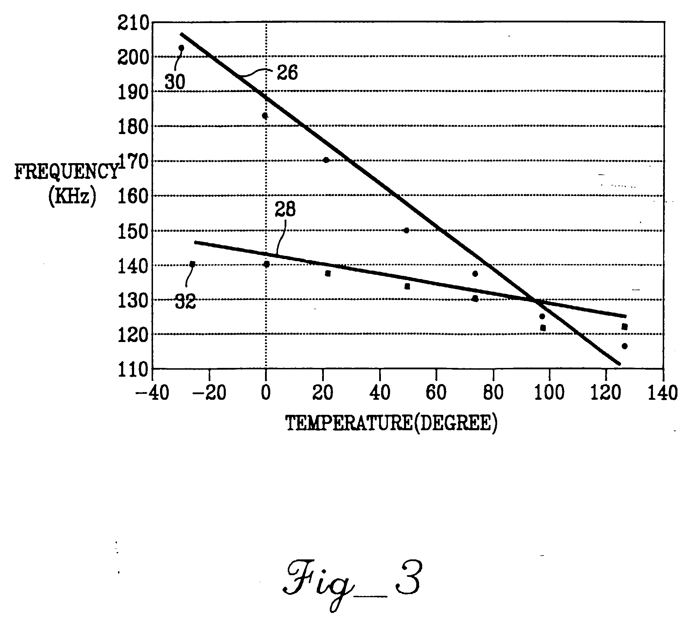

Also, a mechanism in which the amount of leakage current increases as temperature increases by the diode and the resistance 22 is employed. I.V relationship on forward bias and backward bias is as follows:${\text{I=I0(e}}^{\text{vionøT}} \text{- 1),}$ thus
if temperature increases, leakage current increases. The effect according to this embodiment of the present invention is shown in FIG. 3.

FIG. 3 is a graphic view showing results of frequency properties on temperature according to FIG. 2. That is, a measurement on frequency of the output terminal 8 is made by connecting power supply and ground to an element existing in an oscillator, and thus the result of FIG. 3 corresponds to data measured which is based on the power supply and the temperature. With reference to FIG. 3, data 30 and 32 according to an embodiment of forward direction 26 and backward direction 28 are illustrated.

Thus, according to the invention as described above, a means for compensating a change in oscillator frequency of oscillator circuit caused by change of the ambient temperature is provided, thereby attaining the effect of oscillating at a stable frequency.

## Claims

1. A temperature compensated oscillator circuit formed on a semiconductor substrate of a semiconductor device, having
inverting means (2) including a plurality of inverters (14, 16, 18) connected between an input terminal (6) and an output terminal (8) of said inverting means (2),
**characterized by**
feedback resistance means (4) connected to said output terminal (8) and connected between said input terminal (6) and said output terminal (8); and
temperature compensating means (20) connected in parallel with said feedback resistance means (4) and connected between said input terminal (6) and said output terminal (8), to thereby minimize a change in frequency and to decrease a resistance value of said temperature compensating means (20), corresponding to an increase in temperature.

2. The oscillator circuit as claimed in claim 1, wherein said temperature compensating means (20) includes a diode (22) and a resistance.

3. The oscillator circuit as claimed in claim 1, wherein said temperature compensating means (20) includes a transistor (24) whose gate is connected to ground.

## Patentansprüche

1. Temperaturkompensierte Oszillatorschaltung, die auf einem Halbleitersubstrat einer Halbleitervorrichtung ausgebildet ist, und die aufweist:
eine Invertiereinrichtung (2), die eine Vielzahl von Invertem (14, 16, 18) enthält, die zwischen einen Eingangsanschluss (6) und einen Ausgangsanschluss (8) der Invertiereinrichtung (2) geschaltet sind, **gekennzeichnet durch**:
eine Rückkopplungswiderstandseinrichtung (4), die mit dem Ausgangsanschluss (8) verbunden ist und zwischen den Eingangsanschluss (6) und den Ausgangsanschluss (8) geschaltet ist; und
eine Temperaturkompensationseinrichtung (20), die parallel zu der Rückkopplungswiderstandseinrichtung (4) geschaltet ist und zwischen den Eingangsanschluss (6) und den Ausgangsanschluss (8) geschaltet ist, um so eine Verringerung der Frequenz auf ein Minimum zu beschränken und einen Widerstandswert der Temperaturkompensationseinrichtung (20) entsprechend einer Zunahme der Temperatur zu verringern.

2. Oszillatorschaltung nach Anspruch 1, wobei die Temperaturkompensationseinrichtung (20) eine Diode (22) und einen Widerstand enthält.

3. Oszillatorschaltung nach Anspruch 1, wobei die Temperaturkompensationseinrichtung (20) einen Transistor (24) enthält, dessen Gate mit Erde verbunden ist.

## Revendications

1. Circuit oscillateur compensé en température formé sur un substrat semiconducteur d'un dispositif à semiconducteur, comportant des moyens d'inversion (2) incluant une pluralité d'inverseurs (14, 16, 18) connectés entre une borne d'entrée (6) et une borne de sortie (8) desdits moyens d'inversion (2),
caractérisé par :
des moyens à résistance de réaction (4) connectés à ladite borne de sortie (8) et connectés entre ladite borne d'entrée (6) et ladite borne de sortie (8) ; et,
des moyens de compensation de température (20) connectés en parallèle avec lesdits moyens à résistance de réaction (4) et connectés entre ladite borne d'entrée (6) et ladite borne de sortie (8), pour minimaliser ainsi un changement de fréquence et pour réduire une valeur de résistance desdits moyens de compensation de température (20), correspondant à une augmentation de température.

2. Circuit oscillateur selon la revendication 1, dans lequel lesdits moyens de compensation de température (20) comprennent une diode (22) et une résistance.

3. Circuit oscillateur selon la revendication 1, dans lequel lesdits moyens de compensation de température (20) comprennent un transistor (24) dont la grille est connectée à la masse.
